Europäisches Patentamt

European Patent Office

Office européen des brevets

(19)

(11) Veröffentlichungsnummer: **0 220 445**
**A1**

(12) # EUROPÄISCHE PATENTANMELDUNG

(21) Anmeldenummer: **86112455.0**

(22) Anmeldetag: **09.09.86**

(51) Int. Cl.⁴: **H 02 H 9/04**

(30) Priorität: **25.09.85 CH 4141/85**

(43) Veröffentlichungstag der Anmeldung: **06.05.87**
**Patentblatt 87/19**

(84) Benannte Vertragsstaaten: **AT CH DE FR GB IT LI NL SE**

(71) Anmelder: **BBC Aktiengesellschaft Brown, Boveri & Cie., Haselstrasse, CH-5401 Baden (CH)**

(72) Erfinder: **Prochazka, Viktor, Lindenhof 8, CH-5430 Wettingen (CH)**
Erfinder: **Wiegart, Norbert, Dr., im Eichtal 5, CH-5400 Baden (CH)**

(54) **Anordnung zum Unterdrücken von Überspannungsimpulsen.**

(57) Eine Anordnung zum Unterdrücken von Überspannungsimpulsen auf einer Signale zu einem elektrischen Registriergerät führenden Koaxialleitung weist vier jeweils paarweise antiparallel zueinander zwischen den Leiter (1) und die Abschirmung (2) der Koaxialleitung geschaltete Dioden (3, 4, 5, 6) auf.

Mit dieser Anordnung sollen selbst energiereiche Überspannungsimpulse in rascher und einfacher Weise begrenzt werden.

Dies wird dadurch erreicht, dass zwei antiparallel zueinander geschaltete Dioden (z.B. 4, 6) im Vergleich zu den verbleibenden zwei antiparallel zueinander geschalteten Dioden (3, 5) sehr schnell auf Spannungsänderungen ansprechen, und dass die Dioden (3, 4, 5, 6) annähernd sternförmig um den Leiter (1) verteilt sind.

95/85

25.9.85

Ka/eh

- 1 -

## Anordnung zum Unterdrücken
## von Ueberspannungsimpulsen

Bei der Erfindung wird ausgegangen von einer Anordnung zum Unterdrücken von Ueberspannungsimpulsen nach dem ersten Teil von Patentanspruch 1.

Bei dieser Anordnung nimmt die Erfindung auf einen Stand der Technik Bezug, wie er etwa in dem Artikel "Elektromagnetische Verträglichkeit elektrischer Einrichtungen" von J. Meppelink in Elektronik 1983, H. 10, S. 78-83, insbesondere Bild 9, beschrieben ist. Bei der bekannten Anordnung werden unerwünschte Ueberspannungsimpulse, welche auf einer Signale zu einer elektrischen Registriereinrichtung führenden Koaxialleitungen auftreten können, durch eine Schutzschaltung unterdrückt, welche vier paarweise antiparallel zwischen den Leiter und die Abschirmung der Koaxialleitung geschaltete Schaltdioden umfasst. Um bei dieser Anordnung eine kurze Ansprechzeit bei gleichzeitig grossem Energieaufnahmevermögen zu ermöglichen, ist es jedoch erforderlich, die Dioden
vorzuspannen.

Die Erfindung, wie sie im Patentanspruch 1 gekennzeichnet
ist, löst die Aufgabe, eine Anordnung der gattungsgemässen
Art zu schaffen, bei der mit einfachen Mitteln eine
äusserst rasche Begrenzung energiereicher Ueberspannungsimpulse gewährleistet ist.

Die erfindungsgemässe Anordnung zeichnet sich trotz
einfachen Aufbaus durch eine äusserst rasche und wirkungsvolle Begrenzung selbst energiereicher Ueberspannungsimpulse aus und vermeidet zugleich unterhalb ihrer Einsatzschwelle eine Beeinträchtigung der in der Koaxialleitung ermittelten Signale.

Nachfolgend werden Ausführungsbeispiele der Erfindung
anhand der Zeichnung näher erläutert.

Hierbei zeigt:

Fig. 1   Eine Aufsicht auf eine senkrecht zu ihrer Achse
geschnittene Koaxialleitung mit einer ersten
Ausführungsform der erfindungsgemässen Anordnung
zum Unterdrücken von Ueberspannungsimpulsen,

Fig. 2   eine Aufsicht auf eine längs ihrer Achse geschnittene Koaxialleitung mit einer zweiten Ausführungsform der erfindungsgemässen Anordnung zum Unterdrücken von Ueberspannungsimpulsen,

Fig. 3   eine Aufsicht auf eine längs ihrer Achse geschnittene Koaxialleitung mit einer dritten Ausführungsform der erfindungsgemässen Anordnung zum Unterdrücken von Ueberspannungsimpulsen, und

Fig. 4   eine Aufsicht auf eine längs ihrer Achse geschnittene Koaxialleitung mit einer vierten
         Ausführungsform der erfindungsgemässen Anordnung
         zum Unterdrücken von Ueberspannungsimpulsen.

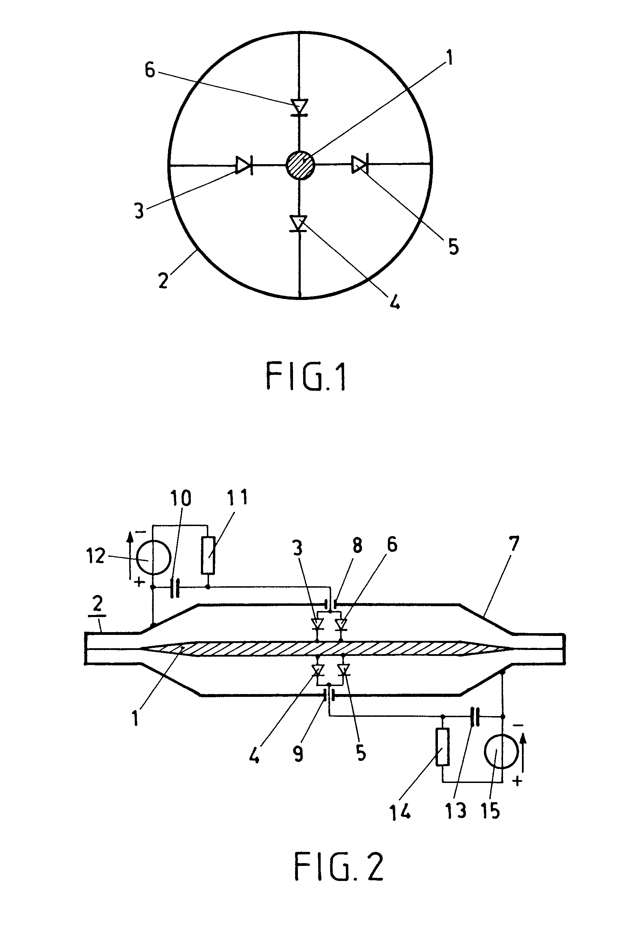

In allen Figuren bezeichnen gleiche Bezugzeichen auch gleichwirkende Teile. Die in Fig. 1 dargestellte Koaxialleitung ist aus einem Spannungssignale zu einem elektrischen Registriergerät, beispielsweise einem Oszillographen, führenden Leiter 1 und einer den Leiter 1 koaxial umgebenden, metallischen Abschirmung 2 aufgebaut. Im Inneren der metallischen Abschirmung 2 befinden sich vier Dioden 3, 4, 5, 6, von denen die Dioden 3 und 6 anodenseitig mit der Abschirmung 2 und kathodenseitig mit dem Leiter 1 und die Dioden 4 und 5 kathodenseitig mit der Abschirmung 2 und anodenseitig mit dem Leiter 1 verbunden sind. Die Dioden 3, 4, 5, 6 sind im wesentlichen sternförmig um den Leiter 1 herum verteilt in einer senkrecht zur Achse der Koaxialleitung verlaufenden Ebene angeordnet, wodurch ein geradlinig erstreckter und daher induktivitätsarmer Strompfad vom Leiter 1 über die Diode 4, 5 zur Aschirmung 2 bzw. von der Abschirmung 2 über die Dioden 3, 6 zum Leiter 1 ermöglicht wird. Je zwei der Dioden, nämlich die Dioden 3, 5 bzw. 4, 6, sind antiparallel zueinander geschaltet. Diese antiparallel geschalteten Dioden sind jeweils vom gleichen Typ. Die Dioden 3 und 5 sind beispielsweise Halbleiterdioden auf der Basis Silicium mit einer steilen Strom-Spannungs-Kennlinie, wie etwa Signaldioden des Typs 1N4448 der Firma Intermetall. Die Dioden 4 und 6 sind im Vergleich zu den Dioden 3 und 5 rasch auf Spannungsänderungen ansprechende Metall-Halbleiter-Dioden, wie etwa Schottky-Dioden, mit einer flachen Strom-Spannungs-Kennlinie, wie beispielsweise Dioden des Typs MBE502 der Firma Motorola.

Beim Auftreten von unerwünschten, etwa durch Schaltvorgänge in elektrischen Energieübertragungsnetzen, hervorgerufenen Ueberspannungsimpulsen von beispielsweise
50 Volt sorgt je nach Polarität der Ueberspannungsimpulse
entweder die schnelle Diode 4 oder die schnelle Diode 6
für eine frühzeitige Begrenzung des Ueberspannungsimpulses
und eine kleine Spannungsspitze. Eine der beiden trägeren
Dioden 3 oder 5 bewirkt sodann wegen ihrer steilen Strom-
Spannungs-Kennlinie eine geringe Restspannung der Ueberspannungsimpulse und die Aufnahme der in diesen Impulsen
enthaltenen Energie. Bedingt durch die induktivitätsarme
Anordnung der Dioden 3, 4, 5, 6 ist deren Ansprechzeit
zusätzlich verkürzt, was zu einer weiteren Reduktion
der Maximalspannung der unerwünschten Ueberspannungsimpulse führt. Zugleich wird die Signalbeeinflussung
infolge der geringen Kapazität des Strompfades in der
vorstehend erörterten Schaltung unterhalb ihrer Einsatzschwelle gering gehalten. Versuche haben ergeben, dass
der Anstieg eines unterhalb der Einsatzschwelle gelegenen
Signals bei Verwendung der vorstehend erörterten Schaltung
lediglich um ca. 30 % gegenüber dem Anstieg eines gleichartigen Signals ohne Verwendung dieser Schaltung erhöht
ist. Für grosse Signale können handelsübliche Breitbandabschwächer vorgeschaltet werden.

Die vorstehende Schaltung lässt sich bevorzugt in einem
die Koaxialleitung abschliessenden Koaxialstecker unterbringen. Aus den nachfolgenden Figuren 2 bis 4 ist ein
in Längsrichtung geschnittenes Steckergehäuse 7 eines
solchen Koaxialsteckers ersichtlich. Im Gegensatz zur
vorstehend beschriebenen Schaltung enthalten die in
diesen Figuren angegebenen Ausführungsformen der Erfindung
jedoch noch zusätzliche Schaltungselemente, welche eine
Vorgabe ihres Ansprechniveaus erlauben. Diese Schaltungselemente befinden sich ausserhalb des Steckergehäuses 7
und sind über Durchführungen 8 bzw. 9 mit den Anoden- bzw. Kathodenanschlüssen der Dioden 3, 6 bzw. 4, 5 verbunden. Um die Ansprechzeit der Dioden 3, 4, 5, 6 gering zu halten, sind hierbei die Kapazitäten der Durchführungen 8, 9 mit höchstens einigen Nanofarad möglichst gering zu halten und sollten darüber hinaus die Durchführungen 8, 9 induktivitätsarm ausgebildet sein.

Bei der Ausführungsform der Erfindung gemäss Fig. 2 sind die Anodenanschlüsse der Dioden 3, 6 mit einem Anschluss eines Kondensators 10 und einem Anschluss eines Widerstandes 11 verbunden. Der andere Anschluss des Widerstandes 11 ist mit dem Minuspol einer Referenzspannungsquelle 12, beispielsweise einer Gleichstrombatterie von 5 Volt Spannung, verbunden. Der Pluspol der Referenzspannungsquelle 12 und der andere Anschluss des Kondensators 10 sind an das Steckergehäuse 7 der Abschirmung 2 angeschlossen. Entsprechend sind die Kathodenanschlüsse der Dioden 4, 5 mit einem Anschluss eines Kondensators 13 und mit einem Anschluss eines Widerstandes 14 verbunden. Der andere Anschluss des Widerstandes 14 ist hingegen mit dem Pluspol einer der Referenzspannungsquelle 12 entsprechenden Referenzspannungsquelle 15 verbunden. Der Minuspol der Referenzspannungsquelle 15 und der andere Anschluss des Kondensators 13 sind an das Steckergehäuse 7 angeschlossen. Die Kondensatoren 10, 13 weisen einander entsprechende möglichst grosse, etwa im Mikrofarad-Bereich liegende, Kapazitätswerte und die Widerstände 11, 14 einander entsprechende, etwa im Kiloohm-Bereich liegende, Werte auf.

Bei dieser Anordnung setzt die Begrenzung beispielsweise bei 5,2 Volt ein. Hierbei werden je nach Polarität der zu begrenzenden Spannungsimpulse entweder der Kondensator 10 (und die als Kondensator wirkende Durchführung 8) oder der Kondensator 13 (und die als Kondensator wirkende Durchführung 9) durch die Ueberspannungsimpulse allmählich weiter aufgeladen. Bei kurzen, etwa im Nanosekunden-Bereich liegenden Ueberspannungsimpulsen kann der durch diese Aufladung bedingte Spannungsanstieg gering gehalten werden, wenn die Kapazitätswerte der Kondensatoren 10, 13 im Mikrofarad-Bereich liegen. Von Vorteil ist es bei der angegebenen Anordnung, dass die Begrenzungsspannung in einfacher Weise durch Aenderung der Grösse der Referenzspannungsquellen 12, 15 verändert werden kann, so dass es beispielsweise möglich ist, bei einem zu schützenden Oszillographeneinschub für jede Stellung seines Eingangsteilers ein Schutzniveau vorzugeben ohne Aenderungen an der Anordnung vornehmen zu müssen.

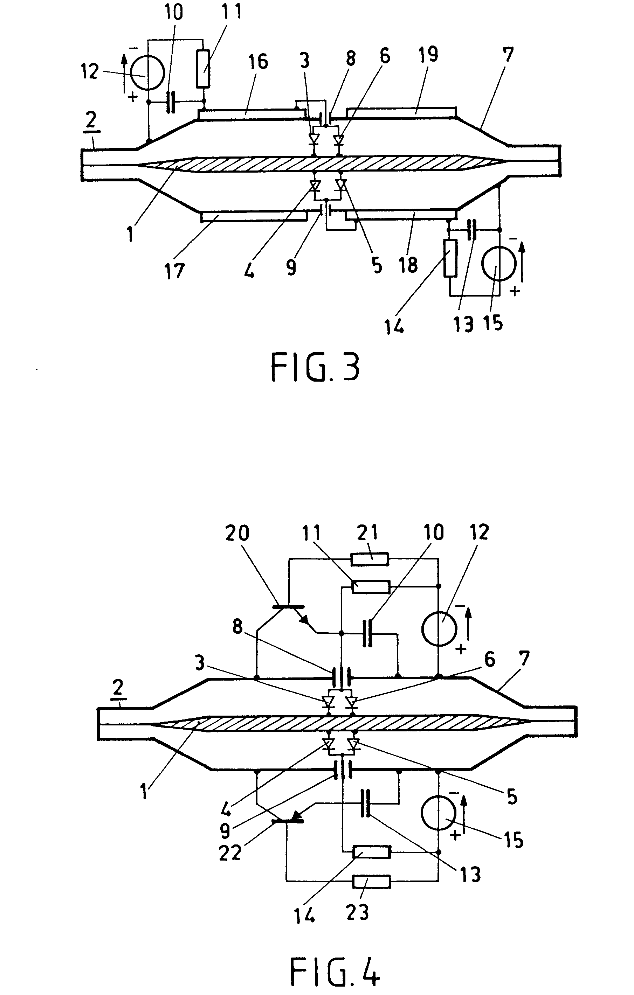

Bei der Anordnung gemäss Fig. 3 sind die Anodenanschlüsse der Dioden 3, 6 über eine Elektrode 16 eines Kondensators 17 an den Kondensator 10 bzw. den Widerstand 11 und entsprechend die Kathodenanschlüsse der Dioden 4, 5 über eine Elektrode 18 eines Kondensators 19 an den Kondensator 13 bzw. den Widerstand 14 geführt. Die Kondensatoren 17 bzw. 19 sind hierbei von dem als Steckergehäuse 7 ausgebildeten Teil der Abschirmung 2 sowie einer um das Steckergehäuse 7 gewickelten Isolierstoffolie gebildet, welche die Elektroden 16 bzw. 18 in Form einer Metallbeschichtung trägt. Hierdurch wird gegenüber der Anordnung gemäss Fig. 2 die kapazitive Ankopplung der Dioden 3, 6 bzw. 4, 5 an die als Rückleiter für Ueberspannungsimpulse wirkende Abschirmung 2 und damit deren Ansprechverhalten verbessert.

Bei der Anordnung gemäss Fig. 4 sind die Anodenanschlüsse der Dioden 3, 6 zusätzlich an den Emitter eines NPN-Transistors 20 geführt, dessen Basis über einen Widerstand 21 mit dem Minuspol der Referenzspannungsquelle 12 und dessen Kollektor mit dem Steckergehäuse 7 der Abschirmung 2 verbunden ist, und die Kathodenanschlüsse der Dioden 4, 5 zusätzlich an den Emitter eines PNP-Transistors 22, dessen Basis über einen Widerstand 23 mit dem Pluspol der Referenzspannungsquelle 15 und dessen Kollektor mit dem Steckergehäuse 7 der Abschirmung 2 verbunden ist. Bei dieser Ausführungsform der Erfindung übernehmen die Transistoren 20, 22 nach dem Ansprechen der Dioden 3, 4, 5, 6 die weitere Begrenzung der Ueberspannungsimpulse, wobei ein unerwünschter Spannungsanstieg der Kondensatoren 10, 13 auch bei längerer, beispielsweise 30 Mikrosekunden betragender Dauer der Ueberspannungsimpule durch die parallel zu jedem dieser Kondensatoren geschalteten als nichtlineare Widerstände wirkenden Emitter-Kollektor-Strecken der Transistoren 20, 22 vermieden wird. Da die Transistoren 20, 22 hierbei nicht die Ansprechzeit der Schutzvorrichtung bestimmen, können Transistortypen mit mittlerer Stromverstärkung und mit grossem Energieaufnahmevermögen verwendet werden, die beispielsweise solche des Typs 2N2905A bzw. 2N2219A der Firma Texas Instruments.

## PATENTANSPRÜCHE

1. Anordnung zum Unterdrücken von Ueberspannungsimpulsen auf einer Signale zu einem elektrischen Registriergerät führende Koaxialleitung, bei der zwischen dem Leiter (1) und der Abschirmung (2) des Koaxialkabels mindestens zwei antiparallel zueinander zwischen den Leiter (1) und die Abschirmung (2) geschaltete erste Dioden (3, 5) vorgesehen sind, dadurch gekennzeichnet, dass zwischen Abschirmung (2) und Leiter (1) zusätzlich mindestens zwei antiparallel zueinander geschaltete und im Vergleich zu den ersten Dioden (3, 5) schnell auf Spannungsänderungen ansprechende zweite Dioden (4, 6) geschaltet sind, und dass die ersten und zweiten Dioden (3, 4, 5, 6) annähernd sternförmig um den Leiter (1) verteilt im Inneren der Abschirmung (2) angeordnet sind.

2. Anordnung nach Anspruch 1, dadurch gekennzeichnet, dass die zweiten Dioden (4, 6) Schottky-Dioden sind.

3. Anordnung nach einem der Ansprüche 1 oder 2, dadurch gekennzeichnet, dass die ersten und zweiten Dioden (3, 4, 5, 6) in einem die Koaxialleitung abschliessenden Koaxialstecker angeordnet sind.

4. Anordnung nach einem der Ansprüche 1 bis 3, dadurch gekennzeichnet, dass die Anodenanschlüsse mindestens einer (3) der ersten (3, 5) und mindestens einer (6) der zweiten Dioden (4, 6) über eine erste Durchführung (8) aus der Abschirmung (2) geführt und über mindestens einen ersten Kondensator (10) sowie eine parallel zum ersten Kondensator (10) geschaltete erste Referenzspannungsquelle (12) mit der Abschirmung (2) verbunden sind, und dass die Kathodenanschlüsse mindestens einer weiteren (5) der ersten (3, 5) und mindestens einer weiteren (4) der zweiten Dioden (4, 6) über eine zweite Durchführung (9) aus der Abschirmung (2) geführt und über mindestens einen zweiten Kondensator (13) sowie eine parallel zum zweiten Kondensator (13) geschaltete und der ersten (12) entgegengesetzt gepolte zweite Referenzspannungsquelle (15) mit der Abschirmung (2) verbunden sind.

5. Anordnung nach Anspruch 4, dadurch gekennzeichnet, dass die Kapazitäten der Durchführung (8, 9) wesentlich kleiner als die Kapazitäten des ersten (10) und des zweiten Kondensators (13) sind.

6. Anordnung nach Anspruch 5, dadurch gekennzeichnet, dass parallel zum ersten (10) und zum zweiten Kondensator (13) jeweils ein weiterer Kondensator (17, 19) liegt, welcher von der Abschirmung (2) und einer um die Abschirmung (2) gewickelten metallbeschichteten Isolierstoffolie gebildet ist.

7. Anordnung nach einem der Ansprüche 4 bis 6, dadurch gekennzeichnet, dass parallel zum ersten (10) und zweiten Kondensator (13) jeweils ein erster und ein zweiter nichtlinearer Widerstand geschaltet ist.

8. Anordnung nach Anspruch 7, dadurch gekennzeichnet, dass der erste nichtlineare Widerstand die Emitter-Kollektor-Strecke eines NPN-Transistors (20) und der zweite nichtlineare Widerstand die Emitter-Kollektor-Strecke eines PNP-Transistors (22) ist.

FIG.1

FIG.2

FIG. 3

FIG. 4

Europäisches
Patentamt

**EUROPÄISCHER RECHERCHENBERICHT**

0220445

Nummer der Anmeldung

EP 86 11 2455

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | REVIEW OF SCIENTIFIC INSTRUMENTS, Band 56, Nr. 9, September 1985, Seiten 1804-1808, American Institute of Physics, Woodbury, New York, US; G.R. MITCHEL et al.: "Subnanosecond protection circuits for oscilloscope inputs" * Seite 1807, rechte Spalte, Zeilen 15-22 * | 1 | H 02 H 9/04 |
| Y | IDEM | 3 | |
| | --- | | |
| Y | IBM TECHNICAL DISCLOSURE BULLETIN, Band 19, Nr. 12, Mai 1977, Seiten 4646,4647, New York, US; F.A. ALMQUIST et al.: "Coaxial surge suppression assembly" * Das ganze Dokument * | 3 | |
| | --- | | RECHERCHIERTE SACHGEBIETE (Int. Cl.4) |
| A | IEEE - THE 14TH CONVENTION OF ELECTRICAL & ELECTRONICS ENGINEERS IN ISRAEL, Tel Aviv, 26-28 März 1985, IEEE, New York, US; I. SHRAGA et al.: "EMP-wideband protection circuits" * Seiten 2,3, Abschnitt: "4. Second Stage" * | 1-4 | H 02 H<br>H 01 R<br>G 01 R |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 31-12-1986 | KOLBE W.H. |

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| A | DE-A-1 488 913 (FUJITSU LTD.)<br>* Das ganze Dokument * | 1-4 | |
| D,A | ELEKTRONIK, Vol. 32, Nr. 10, Mai 1983, Seiten 78-83, München, DE; J. MEPPELINK: "Elektromagnetische Verträglichkeit elektrischer Einrichtungen" * Seiten 82-83, Abschnitt 4,6; Figuren 4-9 * | 1-4 | |

RECHERCHIERTE SACHGEBIETE (Int. Cl. 4)

Der vorliegende Recherchenbericht wurde für alle Patentansprüche erstellt.

| Recherchenort | Abschlußdatum der Recherche | Prüfer |
|---|---|---|
| DEN HAAG | 31-12-1986 | KOLBE W.H. |